# EUROPEAN PATENT APPLICATION

(11) **EP 3 836 208 A1**
(43) Date of publication of application: **16.06.2021**
(21) Application number: 19210137.6
(22) Date of filing: 19.11.2019
(51) Int. Cl.: H01L 23/538

(54) **METHOD AND SYSTEM FOR INTERCONNECTING A POWER DEVICE EMBEDDED IN A SUBSTRATE USING CONDUCTING PASTE INTO CAVITIES**

(71) Applicant: Mitsubishi Electric R & D Centre Europe B.V., 1119 NS Schiphol Rijk (NL); Mitsubishi Electric Corporation, Tokyo 100-8310 (JP)
(72) Inventor: MORAND, Julien, 35708 Rennes Cedex 7 (FR); MOLLOV, Stefan, 35708 RENNES Cedex 7 (FR)
(74) Representative: Cabinet Le Guen Maillet

(57) **Abstract**

The present invention concerns a method and a system for interconnecting a power device embedded in a substrate using conducting paste into cavities. The present invention:
- embeds the power die in a substrate composed of a dielectric material comprising a metallization layer on the top and bottom surfaces of the dielectric material,
- etches the substrate on the top and bottom surfaces of the power die,
- plates a conductive material on the whole surface of the cavities to connect the power die electrodes with the conductive material layer on the top and bottom surfaces of the dielectric material,
- fills the plated cavities with a paste made of electrical and thermal conductive material and additive components,
- stabilizes the conducting paste in order to evaporate or burn out the additives of the conducting paste,
- plates a conductive material on the top and on the bottom of the substrate.

## Description

### TECHNICAL FIELD

The present invention relates generally to a method and system for interconnecting a power device embedded in a substrate suing conducting paste into cavities.

### RELATED ART

Increase of switching frequency and power density lead to a constant need for thermal enhancement of power electronic packaging. Nowadays, the most common way to connect a power die like a diode, a MOSFET, a JFET or an IGBT transistor to the external components is the use of an insulated plate such as a Direct Bonded Copper (DBC) Substrate on one side and wire bonding on the other one. The lower side of the power die is attached to the substrate by soldering or sintering. The other side of the power die is connected by multiple wire bonds or ribbons that are ultrasonic welded on the die metallisation.

An emerging solution in power packaging is to embed the die into a substrate, like for example a printer circuit board PCB, and connect the components by copper vias.

Recently, attempts of replacing the copper vias have been found in the literature. In the paper of C. Dimarino entitled "Desing of a novel, high density, high speed 10kV SiC MOSFET module" published in 2017 in IEEE Energy Conversion Congress and Exposition pages 4003 to 4011, a macroscopic cavity is cut-out on only the top of the power die. The exposed electrodes are previously plated with a thin layer of copper. An electro-less copper plating is then performed to connect the top copper layer with the power die electrodes, here the anode. Electro-less deposition is limited in term of thickness, at most a few tens of µm. The equivalent electric resistance and more importantly the thermal one is reduced with such a thin layer. An additional step of electrodeposition can be performed to thicken the contact layer but the obtained thickness is also limited. Because of the cavity form factor, wide surface and a small height, the electrodeposition process can't entirely filled the void with copper resulting in a non-optimal resistance.

In the paper of V. Smet entitled ", Advanced materials, designs and 3D package architectures for next gen high power packaging" published in Applied electronics conference in 2019, a foam of copper is grown on the wafer level and then sinter on the substrate. Although being compatible with the die manufacturing process, the multiple steps for the deposition of a Cu-Zn alloy, then de-alloying (selectively remove the Zn) and finally sintering are expensive ones. In addition, sintering is an attach process that generally requires pressure and high temperature that are not compatible with the PCB process.

### SUMMARY OF THE INVENTION

The present invention aims to provide an alternative process for connecting the electrodes of an embedded power device. The process is based upon a sequence of steps that permit a cavity to be filled with a conductive material ensuring both a good electrical and thermal contact with the outer world.

To that end, the present invention concerns a method for interconnecting a power device embedded in a substrate using conducting paste into cavities characterized in that the method comprises the steps of:
- embedding the power die in a substrate composed of a dielectric material comprising a metallization layer on the top and bottom surfaces of the dielectric material,
- etching the substrate on the top and bottom surfaces of the power die,
- plating a conductive material on the whole surface of the cavities to connect the power die electrodes with the conductive material layer on the top and bottom surfaces of the dielectric material,
- filling the plated cavities with a paste made of electrical and thermal conductive material and additive components,
- stabilizing the conducting paste in order to evaporate or burn out the additives of the conducting paste,
- plating a conductive material on the top and on the bottom of the substrate.

The present invention concerns also a system for interconnecting a power device embedded in a substrate using conducting paste into cavities characterized in that the system comprises:
- means for embedding the power die in a substrate composed of a dielectric material comprising a metallization layer on the top and bottom surfaces of the dielectric material,
- means for etching the substrate on the top and bottom surfaces of the power die,
- means for plating a conductive material on the whole surface of the cavities to connect the power die electrodes with the conductive material layer on the top and bottom surfaces of the dielectric material,
- means for filling the plated cavities with a paste made of electrical and thermal conductive material and additive components,
- means for stabilizing the conducting paste in order to evaporate or burn out the additives of the conducting paste,
- means for plating a conductive material on the top and on the bottom of the substrate.

Thus, the present invention provides an alternative process for connecting the electrodes of an embedded power device. The process is based upon a sequence of steps that permit a cavity to be filled with a conductive material ensuring both a good electrical and thermal contact with the outer world.

According to a particular feature, the additive components are solvants and/or binders and/or plasticizers and/or cleaners.

Thus, the conducting paste have the proper viscosity to enable deposition by screen printing. Cleaning adjuvants also remove the possible oxidation layer on the particles before the encapsulation

According to a particular feature, the electrical and thermal conductive material is composed of particles of silver or copper or tin.

Thus, both the electrical and thermal conductivities are enhanced by these high conductivity materials.

### BRIEF DESCRIPTION OF THE DRAWINGS

The characteristics of the invention will emerge more clearly from a reading of the following description of example embodiments, the said description being produced with reference to the accompanying drawings, among which:
Figs. 1, 2 and 3 represent an example of a power die that is embedded in a substrate according to the present invention;
Fig. 4 represents an example of a cavity cut out of the substrate according to the present invention;
Fig. 5 represents an example of a conductive plating of the substrate according to the present invention;
Fig. 6 represents an example of a conducting paste filling of the cavities according to the present invention;
Fig. 7 represents an example of the substrate after a stabilization of the conducting paste filled in the cavities;
Fig. 8 represents an example of a sealing of the substrate with conductive material;
Fig. 9 represents an example of an architecture of a system for interconnecting a power device embedded in a substrate suing conducting paste into cavities according to the present invention;
Fig. 10 represents an example of an algorithm for interconnecting a power device embedded in a substrate suing conducting paste into cavities according to the present invention.

### DESCRIPTION

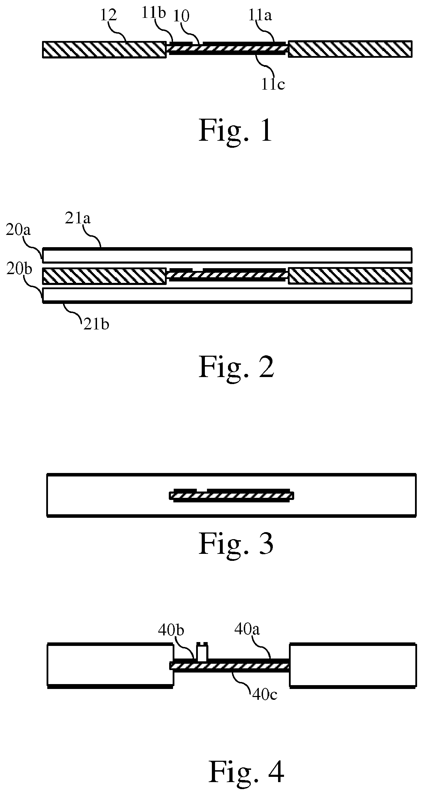

**Figs. 1, 2 and 3** represent an example of a power die that is embedded in a substrate according to the present invention.

In the Fig. 1, a power die 10 is inserted into a cavity of an insulating substrate 12. In the example of Fig. 1, the power die 10 is a transistor having a source electrode 11a, a gate electrode 11b and a drain electrode 11c.

The substrate is for example of PCB.

The power die 10 inserted in the cavity of the substrate 12 is embedded between two substrates 20a and 20b composed of a dielectric material and that are respectively covered by a metallization layer 21a, respectively 20b as shown in Fig. 2 in order to form the substrate of Fig. 3.

**Fig. 4** represents an example of a cavity cut out of the substrate according to the present invention.

The metallizations 21a and 21b are eched on the top and bottom surface of the power die 10 and a part of the dielectric material 20a and 20b is removed following the exact same pattern as the metallization etching. This step is for example carried out by a CO2 or a mid-infrared laser because of the selectivity of this equipment. Indeed, if the beam has to cut through the dielectric material, the electrodes of the die have to remain intact. Most of the metals used for metalization of power dies such as aluminum, copper, silver have a low absobtion coefficient to mid-infrared waves. So, even if the beam is hitting the electrodes surface, no damage is created. Most of the time, a passivation surface is present in the power die around each electrode to avoid arcing. As the cut-out has the same shape than the electrodes, the passivation surfaces are still covered with the cured dielectric. Therefore, the power die is still hold in the dielectric material conferring stiffness to the assembly. The cavities 40a, 40b and 40c are then formed.

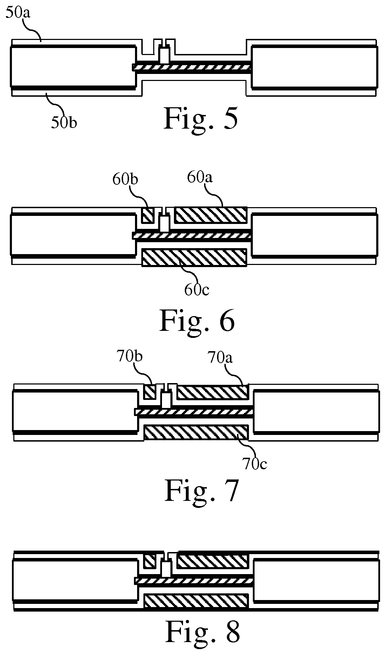

**Fig. 5** represents an example of a conductive plating of the substrate according to the present invention.

Once cavities are cut out, the electrodes of the power die are accessible from outside. Then, a conductive material 50a and 50b is plated on the whole surface of the cavities to connect the power die electrodes with the related conductive material layer on the top and bottom of the power die. Since the surface of the interconnect is, at this time of the process, a series of conductive (copper) and non-conductive (dielectric) layers an electro-less plating is preferred. The plating material does not need to be the same as the conductive material chosen in the substrate structure. The only requirement is a plating compatibility with it. As copper is often the preferred material for the substrate, copper plating is the most common choice. But nickel plating can be applied. This plating step has two goals. The first one is to create an electrical connection between the die electrodes and the copper layers of the substrate. The second one is to create cavities the whole surface of which is covered with a layer of conductive material preventing flowing of the material applied on the process disclosed in Fig. 6 into the possible voids.

**Fig. 6** represents an example of a conducting paste filling of the cavities according to the present invention.

The plated cavities are filled with a paste made of electrical and thermal conductive material and additive components such as solvants, binders, plasticizer, and cleaner.

The filled cavities are noted 60a, 60b and 60c in Fig. 6.

The paste is deposited for example with a standard squeegee technique using either a stencil or a printscreen. Possible type of conductive material includes silver or copper paste used in sintering of power dies, solder paste (tin-rich paste), conductive thermal grease charged with conductive particles such as silver or copper.

The amount of paste placed in the cavity may be determined in order to have the same volume as the cavity once the stabilization of the conducting paste filled in the cavities is performed.

The wording stabilizing may be replaced by drying or curing.

**Fig. 7** represents an example of the substrate after a stabilization of the conducting paste filled in the cavities.

The stabilization or drying of the conducting paste is performed in order to evaporate or burn out the additives of the conducting paste resulting in a more dense material. At the end of this process, the stabilized paste is composed of a myriad of solid particles that are not yet linked together. The volume being reduced by the previous step of evaporation, the level of the filling material is now approximately flushed with the substrate conductive layer at the edges of the cavities. This curing step is carried out at temperature below the fusion or sintering threshold of the solid particules. Its sole purpose is to extract all the additives from the paste.

The stabilized paste in filled cavities are noted 70a, 70b and 70c in Fig. 7.

**Fig. 8** represents an example of a sealing of the substrate with conductive material.

The sealing of the substrate is for example performed by plating a conductive material 80a and 80b on the top and on the bottom of the substrate 80b. The plating of the conductive material protects the stabilized conducting paste from oxidation. The plated material has to be compatible with both the conductive layer material of the substrate and the stabilized conducting paste. This operation will seal the stabilized conducting paste with a plated material. Thus, in case of a phase change in the stabilized conducting paste, no liquid is escaping from the bottom cavity due to the gravity.

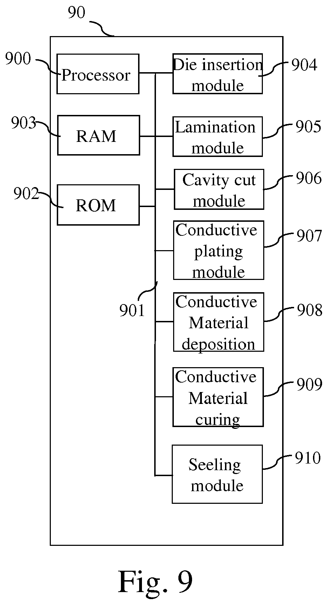

**Fig. 9** represents an example of an architecture of a system for interconnecting a power device embedded in a substrate suing conducting paste into cavities according to the present invention.

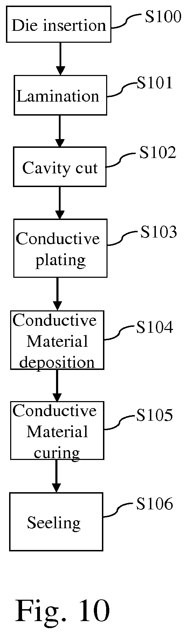

The system 90 for interconnecting a power device embedded in a substrate suing conducting paste into cavities has, for example, an architecture based on components connected together by a bus 901 and a processor 900 controlled by a program as disclosed in Fig. 10.

The bus 901 links the processor 900 to a read only memory ROM 902, a random access memory RAM 903, a power die insertion module 904, a lamination module 905, a cavity cut module 906, a conductive layer plating module 907, a conductive material deposition module 908, a conductive material curing module 909 and a sealing module 910.

The memory 903 contains registers intended to receive variables and the instructions of the program related to the algorithm as disclosed in Fig. 10.

The read-only memory, or possibly a flash memory 902, contains instructions of the program related to the algorithm as disclosed in Fig. 10.

When the system 90 is powered on, the instructions stored in the memory 903 are transferred to the random access memory 903.

The system 90 may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*).

In other words, the system 90 includes circuitry, or a device including circuitry, enabling the system 90 to perform the program related to the algorithm as disclosed in Fig. 9.

The power die insertion module 904 inserts a power die 10 in a cavity of an insulating substrate as shown in Fig. 1.

The lamination module 905 embeds the power die 10 and the substrate 12 between two substrates 20a and 20b composed of a dielectric material that are respectively covered by a metallization layer 21a, respectively 20b as shown in Fig. 2 in order to form the substrate of Fig. 3.

The cavity cut module 906 etches the substrates 20a and 20b on the top and bottom surfaces of the power die 10 and removes a part of the dielectric material 20a and 20b following the exact same pattern as the metallization etching as shown in Fig. 4.

The conductive layer plating module 907 plates a conductive material on the whole surface of the cavities to connect the power die electrodes with the related conductive material layer on top and bottom of the power die as shown in Fig. 5. For example, an electro-less plating is performed.

The conductive material deposition module 908 fills, as shown in Fig. 6, the plated cavities with a paste made of electrical and thermal conductive material and additive components such as solvants, binders, plasticizer, and cleaner.

The paste is deposited for example with a standard squeegee technique using either a stencil or a printscreen.

The conductive material curing module 909 stabilizes the conducting paste in order to evaporate or burn out the additives of the conducting paste resulting in a more dense material as shown in Fig. 7.

The sealing module 910 plates a conductive material on the top and on the bottom of the substrate as shown in Fig. 8.

Fig. 9 represents an example of an algorithm for interconnecting a power device embedded in a substrate suing conducting paste into cavities according to the present invention.

The present algorithm is executed in an example wherein it is executed by the processor 900 of the system 90 for interconnecting a power device embedded in a substrate suing conducting paste into cavities.

At step S100, the processor 900 comands the power die insertion module 904 in order to insert a power die 10 in a cavity of an insulating substrate as shown in Fig. 1.

At step S101, the processor 900 comands the lamination module 905 in order to embed the power die 10 and the substrate 12 between two substrates 20a and 20b composed of a dielectric material that are respectively covered by a metallization layer 21a, respectively 20b as shown in Fig. 2 in order to form the substrate of Fig. 3.

At step S102, the processor 900 comands the cavity cut module 906 in order to etch the substrates 20a and 20b on the top and bottom surface of the power die 10 and to remove a part of the dielectric material 20a and 20b following the exact same pattern as the metallization etching as shown in Fig. 4.

At step S103, the processor 900 comands the conductive layer plating module 907 to plate a conductive material on the whole surface of the cavities to connect the power die electrodes with the related conductive material layer on top and bottom of the power die as shown in Fig. 5.

At step S104, the processor 900 comands the conductive material deposition module 908 in order to fill, as shown in Fig. 6, the plated cavities with a paste made of electrical and thermal conductive material and additive components such as solvants, binders, plasticizer, and cleaner.

At step S105, the processor 900 comands the conductive material curing module 909 in order to sstabilize the conducting paste in order to evaporate or burn out the additives of the conducting paste resulting in a more dense material as shown in Fig. 7.

At step S106, the processor 900 comands the sealing module 910 in order to plate a conductive material on the top and on the bottom of the substrate as shown in Fig. 8.

Naturally, many modifications can be made to the embodiments of the invention
described above without departing from the scope of the present invention.

## Claims

1. A method for interconnecting a power device embedded in a substrate using conducting paste into cavities **characterized in that** the method comprises the steps of:
- embedding the power die in a substrate composed of a dielectric material comprising a metallization layer on the top and bottom surfaces of the dielectric material,
- etching the substrate on the top and bottom surfaces of the power die,
- plating a conductive material on the whole surface of the cavities to connect the power die electrodes with the conductive material layer on the top and bottom surfaces of the dielectric material,
- filling the plated cavities with a paste made of electrical and thermal conductive material and additive components.
- stabilizing the conducting paste in order to evaporate or burn out the additives of the conducting paste,
- plating a conductive material on the top and on the bottom of the substrate.

2. The method according to claim 1, **characterized in that** the additive components are solvants and/or binders and/or plasticizers and/or cleaners.

3. The method according to claim 1 or 2, **characterized in that** the electrical and thermal conductive material is composed of particles of silver or copper or tin.

4. A system for interconnecting a power device embedded in a substrate using conducting paste into cavities **characterized in that** the system comprises:
- means for embedding the power die in a substrate composed of a dielectric material comprising a metallization layer on a top and bottom surfaces of the dielectric material,
- means for etching the substrate on the top and bottom surfaces of the power die,
- means for plating a conductive material on the whole surface of the cavities to connect the power die electrodes with the conductive material layer on top and bottom surfaces of the dielectric material,
- means for filling the plated cavities with a paste made of electrical and thermal conductive material and additive components.
- means for stabilizing the conducting paste in order to evaporate or burn out the additives of the conducting paste,
- means for plating a conductive material on the top and on the bottom of the substrate.

5. The device according to claim 4, **characterized in that** the additive components are solvants and/or binders and/or plasticizers and/or cleaners.

6. The device according to claim 4 or 5, **characterized in that** the electrical and thermal conductive material is composed of particles of silver or copper or tin.
